Europäisches Patentamt

European Patent Office

Office européen des brevets

(11) Veröffentlichungsnummer: **0 390 935**
**A1**

# EUROPÄISCHE PATENTANMELDUNG

(21) Anmeldenummer: **89105569.1**

(22) Anmeldetag: **29.03.89**

(51) Int. Cl.5: **G01R 33/022**

(43) Veröffentlichungstag der Anmeldung:
**10.10.90 Patentblatt 90/41**

(84) Benannte Vertragsstaaten:
**DE FR IT NL**

(71) Anmelder: **Siemens Aktiengesellschaft**
**Wittelsbacherplatz 2**
**D-8000 München 2(DE)**

(72) Erfinder: **Röhrlein, Gerhard, Dr.Ing.**
**Klingenweg 9**
**D-8521 Hessdorf(DE)**
Erfinder: **Seifert, Heinrich, Dr.rer.nat.**
**Lachnerstrasse 63**
**D-8520 Erlangen(DE)**

(54) Verfahren zum Kalibrieren von Mehrkanal-Squid-Systemen mit Gradiometern beliebiger Ordnung.

(57) Bei einem Verfahren zum Kalibrieren von Mehrkanal-Squid-Systemen mit Gradiometern beliebiger Ordnung sind jeder Gradiometerspule symmetrisch, in gleichen Abständen zwischen den parallelen Spulenebenen angeordnete Kalibrierungsspulen (4, 5) zugeordnet, so daß jede Gradiometerspule (1, 2) von den gemeinsamen, entgegengesetzt gerichteten Magnetfeldern dieser Kalibrierungsspulen (4, 5) gleicher Amperewindungszahl durchdrungen wird und das Feld, das die Kalibrierungsspulen (4, 5) an den Orten der Gradiometerspulen (1, 2) hervorrufen, numerisch berechnet und durch die gemessene Spannung am Ausgang der zugeordneten SQUID-Elektronik zur Bestimmung des Kalibrierungsfaktors dividiert wird.

FIG 3

EP 0 390 935 A1

## Verfahren zum Kalibrieren von Mehrkanal-Squid-Systemen mit Gradiometern beliebiger Ordnung

Die Erfindung betrifft ein Verfahren zum Kalibrieren von Mehrkanal-Squid-Systemen mit Gradiometern beliebiger Ordnung nach dem Oberbegriff des Patentanspruchs 1 und Anordnungen zur Durchführung dieses Verfahrens.

Gradiometer mit Squid-Systemen der oben genannten Art dienen dazu, schwache magnetische Felder zu messen und deren Stromquellen zu lokalisieren. Insbesondere Mehrkanalsysteme dieser Art haben in der medizinischen Technik zur Messung der vom Hirn und vom Herzen ausgehenden magnetischen Felder Bedeutung erlangt. Diese Signale werden zur Anfertigung von Magnetoenzephalogrammen (MEG) und Magnetokardiogrammen (MKG) benötigt, um den zeitlichen Verlauf von Aktionsströmen dieser Organe und deren räumliche Zuordnung zu erfassen.

Eine wesentliche Voraussetzung für eine genaue Quellenlokalisation mit Hilfe von Mehrkanal-Squid-Systemen mit Gradiometern ist eine exakte Kalibrierung jedes dieser Systeme. Dabei bedeutet Kalibrierung die Bestimmung des Wandlungsfaktors als Verhältnis der magnetischen Flußdichte an der Sensorspule (Pickup-Spule) zu der elektrischen Spannung am Ausgang der Ansteuerelektronik des Squid-Systems. Eine solche Kalibrierungseinrichtung für Mehrkanal-Systeme dieser Art ist in IEEE Transactions in Biomedical Engineering (in Press 1988) unter dem Titel "SQUID ARRAYS FOR SIMULTANEOUS MAGNETIC MEASUREMENTS: CALIBRATION AND SOURCE LOCALIZATION PERFORMANCE" von P. Costa Ribeiro, S.J. Williamson und L. Kaufman beschrieben. Dieses bekannte Verfahren arbeitet zwar gegenüber älteren Verfahren, die lediglich eine Genauigkeit von etwa 10 % erreichten, mit einer erheblich größeren Genauigkeit von etwa 2 %. Dabei ist aber ein ideales Gradiometer vorausgesetzt, das keinen Fehlabgleich des homogenen Anteils des angelegten Feldes hervorruft. Ein reales Gradiometer besitzt jedoch einen solchen Fehlabgleich, der dazu führt, daß der homogene Anteil des angelegten Kalibrierungsfeldes eine Spannung Vf am Verstärkerausgang hervorruft, der die Meßspannung V verfälscht und der bei Gradiometern zweiter und höherer Ordnung noch steigt. Es ist zwar möglich, bei genauer Kenntnis des Fehlabgleichfaktors f diese Spannung Vf zu berechnen und von der Meßspannung V zu subtrahieren. Eine genaue Messung des Fehlabgleichfaktors f ist jedoch sehr aufwendig. Es ist nämlich dazu erforderlich, ein sehr homogenes Magnetfeld und für Gradiometer n-ter Ordnung zusätzlich exakte Feldgradienten bis (n-1)-ter Ordnung zu erzeugen.

Der Erfindung liegt die Aufgabe zugrunde, diesen Aufwand zu vermeiden und ein Kalibrierungssystem zu schaffen, bei dem ein Gradiometer-Fehlabgleich nicht in die Kalibrierungsmessung eingeht.

Diese Aufgabe wird erfindungsgemäß durch das im Patentanspruch 1 angegebene Verfahren gelöst. Durch ein solches Verfahren mit symmetrisch entgegengesetzt gerichteten Magnetfeldern ist erreicht, daß der homogene Feldanteil zu Null wird und dadurch ein Fehlabgleich eines realen Gradiometers nicht zu einer Fehlerspannung Vf am Ausgang der SQUID-Elektronik führen kann.

Weitere Einzelheiten der Erfindung sind in den Unteransprüchen gekennzeichnet.

Ein Ausführungsbeispiel wird anhand von schematischen Darstellungen im folgenden näher erläutert. Darin zeigen:

Fig. 1 ein Gradiometer erster Ordnung;

Fig. 2 ein Gradiometer zweiter Ordnung;

Fig. 3 ein Gradiometer erster Ordnung mit zugeordneten Kalibrierungsspulen;

Fig. 4 eine schematische Darstellung einer Kalibrierungsanordnung für ein Gradiometer erster Ordnung; und

Fig. 5 eine schematische Darstellung einer Kalibrierungsanordnung für ein Gradiometer zweiter Ordnung.

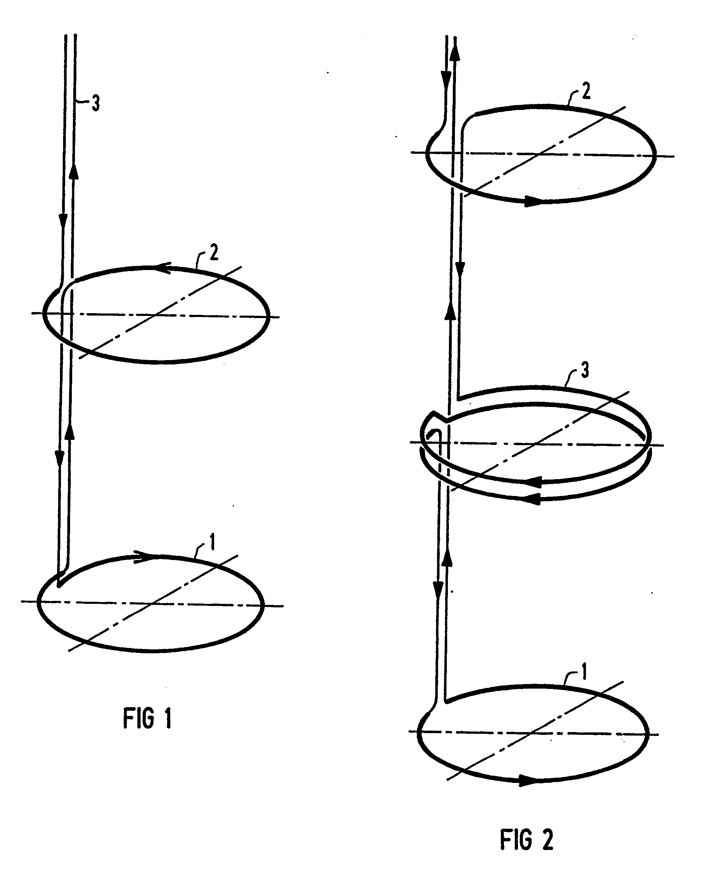

In Fig. 1 ist die Spulenanordnung eines axialen Gradiometers erster Ordnung schematisch dargestellt. Dieses besteht aus zwei in einem axialen Abstand voneinander angeordneten, elektrisch in Serie geschalteten Spulen mit parallelliegenden Spulenebenen. Die untere, dem zu messenden Magnetfeld zugeordnete Spule, ist die sogenannte Pickup-Spule 1, während die obere als Kompensationsspule 2 in der Weise mit der Pickup-Spule zusammenwirkt, daß homogene, von entfernten Quellen stammende Magnetfelder, die beide Spulen durchdringen, wegen der Gegensinnigkeit der Spulenwicklungen kompensiert werden. Beide Spulen sind über eine induktive Kopplung mit einem Superconducting Quantum Interference Device (Squid) verbunden und von einem Dewar-Gefäß umschlossen, welches durch Kühlung mit flüssigem Helium auf einer Temperatur von 4,2° K gehalten wird. Der Aufbau und die Funktion eines solchen Gradiometers ist in der Zeitschrift "Bild der Wissenschaft", Heft 8, 1986, Seiten 76-83 beschrieben und bedarf daher keiner näheren Erläuterung.

Die in Fig. 2 dargestellte Spulenanordnung eines Gradiometers zweiter Ordnung besitzt zusätzlich zu den beiden genannten Spulen eine zwischen diesen angeordnete Zentralspule 3, deren zwei Windungen gleichsinnig gewickelt und elektrisch in Serie geschaltet sind. Der Wicklungssinn der beiden Wicklungen der Zentralspule 3 ist entgegengesetzt demjenigen der Pickup-Spule 1 und der Kompensationsspule 2. Dabei ist der Wicklungssinn der Kompensationsspule 2 demjenigen der Pickup-Spule 1 gleichgerichtet. Alle drei Spulen sind elektrisch in Serie geschaltet und über eine nicht dargestellte induktive Kopplung mit dem zugeordneten Squid verbunden. Die Art des Zusammenwirkens der drei Spulen eines solchen Gradiometers zweiter Ordnung ist in IEEE Transactions in Biomedical Engineering unter dem Titel "SQUID ARRAYS FOR SIMULTANEOUS MAGNETIC MEASUREMENTS: CALIBRATION AND SOURCE LOCALIZATION PERFORMANCE" von P. Costa Ribeiro, S.J. Williamson und L. Kaufman, Seite 3 unter A. "Large-Coil Calibration Technique" beschrieben und bedarf daher keiner näheren Erläuterung.

Bei dem in dieser Arbeit ebenfalls beschriebenen Kalibrierungsverfahren wird eine Kalibrierungsspule in der Ebene der Pickup-Spule 1 angeordnet und erzeugt ein Magnetfeld, welches bei einem Gradiometer erster Ordnung sowohl die Pickup-Spule 1 wie die Kompensationsspule 2 in unterschiedlicher Stärke durchdringt. Die Größe der Feldstärke in der Ebene der Pickup-Spule und der Kompensationsspule wird zunächst numerisch berechnet. Dann wird die Differenz der beiden Felder gebildet und dieser Differenzwert durch die am Ausgang des Pickup-Verstärkers entstehende Meßspannung V dividiert. Der so erhaltene Wert ist der sogenannte Kalibrierungsfaktor k. Nun besitzt ein reales Gradiometer einen Fehlabgleich, der bewirkt, daß der von den beiden Spulen aufgrund der sie durchdringenden Felder erzeugte Strom von dem aufgrund des Gradientenfeldes tatsächlich erzeugten Strom abweicht. Der Grad der Abweichung läßt sich in einer Fehlerspannung Vf ausdrücken, die die Meßspannung V verfälscht. Bei genauer Kenntnis des Fehlabgleichfaktors f kann diese Fehlerspannung Vf berechnet und von der Meßspannung V subtrahiert werden. Eine genaue Messung des Fehlabgleichfaktors f ist jedoch deshalb sehr aufwendig, weil es dazu der Erzeugung eines sehr homogenen Kompensationsmagnetfeldes und für Gradiometer n-ter Ordnung zusätzlich exakter Feldgradienten bis (n-1)-ter Ordnung bedarf.

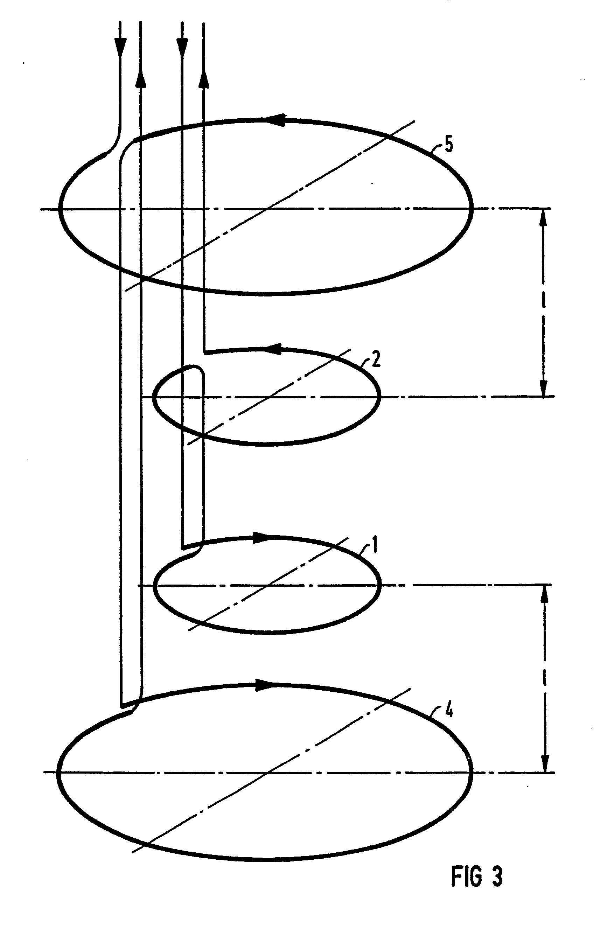

Dieser Aufwand kann durch eine in Fig. 3 dargestellte Kalibrierungsspulenanordnung bei gleicher Genauigkeit erheblich vermindert werden. Zunächst ist davon auszugehen, daß die Fehlerspannung Vf von den homogenen Magnetfeldanteilen in den Spulenebenen hervorgerufen wird. Dieser homogene Anteil Bh ist die Summe der Magnetfelder in den Ebenen der beteiligten Spulen: $Bh = B1 + B2$, wobei B1 das Feld in der Ebene der Pick-up-Spule 1 und B2 das Feld in der Ebene der Kompensationsspule 2 bei einem Gradiometer erster Ordnung gemäß Fig. 1 ist. Wird nun dafür gesorgt, daß ein homogener Feldanteil nicht auftritt, d.h. Null ist, so geht ein Gradiometer-Fehlabgleich grundsätzlich nicht in die Kalibrierungsmessung ein. Dies läßt sich durch eine Anordnung gemäß Fig. 3 erreichen. Dort ist ein Gradiometer erster Ordnung mit der Pickup-Spule 1 und der Kompensationsspule 2 dargestellt. Dies entspricht einer Anordnung nach Fig. 1. Die Kalibrierungsspulen 4 und 5 sind achssymmetrisch und in gleichen Abständen 1 der parallelliegenden Spulenebenen angeordnet. Die Kalibrierungsspulen 4 und 5 sind elektrisch in Serie geschaltet und besitzen die gleichen Windungszahlen. Der Wicklungssinn der Kompensationsspulen 4 und 5 ist entgegengesetzt gerichtet.

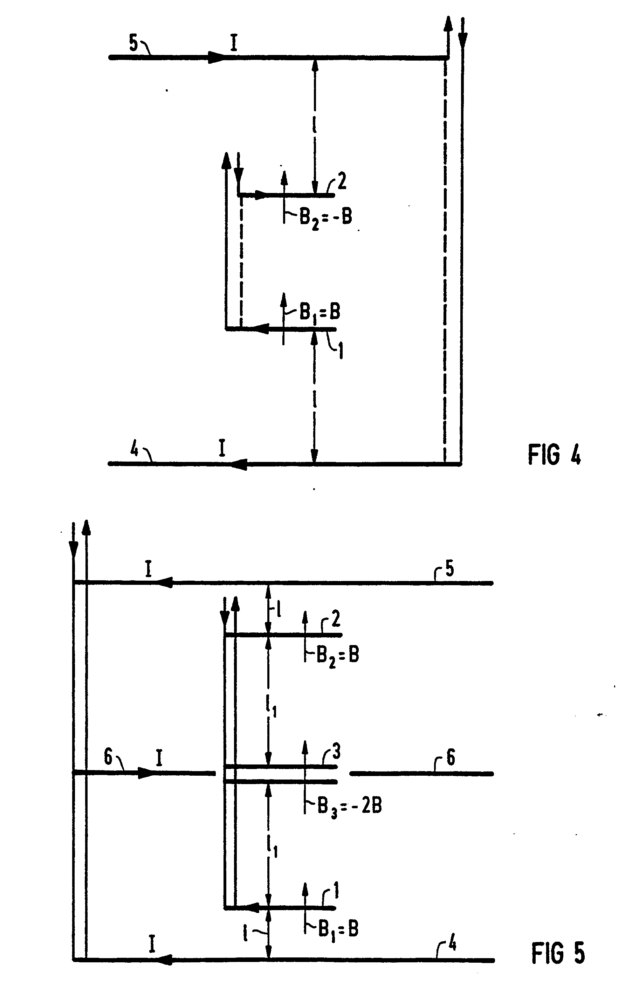

Diese Anordnung ist in Fig. 4 stark schematisiert dargestellt. Der durch die Kalibrierungsspulen 4 und 5 fließende Wechselstrom I erzeugt an der Pickup-Spule 1 des Gradiometers ein Feld $B1 = B$ und an der Kompensationsspule 2 ein Feld $B2 = -B$. Demzufolge gilt für den homogenen Feldanteil Bh:

$$Bh = B1 + B2 = B - B = 0.$$

Gemessen wird dabei der erste Feldgradient Bg1:

$$Bg1 = B1 - B2 = B - (-B) = 2B.$$

Für die Kalibrierung wird der Feldgradient über den Gradiometerspulen berechnet und durch die gemessene Meßspannung V am Ausgang der SQUID-Elektronik dividiert.

In Fig. 5 sind die Verhältnisse an einem Gradiometer zweiter Ordnung gemäß Fig. 2 dargestellt. Dabei liegt in der Ebene der Zentralspule 3 eine weitere Kalibrierungsspule 6. Die Abstände zwischen der Pickup-Spule 1 und der Zentralspule 3 sowie zwischen dieser und der Kompensationsspule 2 sind mit $1_1$ bezeichnet. Bei dieser Anordnung muß dafür gesorgt werden, daß sowohl das homogene Magnetfeld Bh über den Gradiometerspulen als auch der Gradient erster Ordnung Bg1 zu Null werden.

$$Bh = B1 + B2 + B3 = 0$$
$$Bg1 = (B1 - B3) + (B3 - B2) = B1 - B2 = 0$$

Am Gradiometer wird der Gradient zweiter Ordnung Bg2 gemessen:

$$Bg2 = (B1 - B3) - (B3 - B2) = B1 - 2 B3 + B2$$

Damit nun $Bh = 0$ und $Bg1 = 0$ werden, muß durch die Kalibrierungsspulen 4, 5, 6 folgende Feldverteilung am Gradiometer herrschen:

$$B1 = B; B3 = B \text{ und } B2 = -2 B;$$

daraus ergibt sich:

$$Bg2 = 6 B; Bg1 = 0 \text{ und } Bh = 0.$$

Diese Feldverteilung kann durch drei oder auch mehr symmetrisch in der Höhe um die Gradiometerspulen verteilt angeordnete Kalibrierungsspulen erzeugt werden. Dabei kommt es auf die Abstände der Kalibrierungsspulen zu den Gradiometerspulen und das Verhältnis der Windungszahlen zwischen den Kalibrierungsspulen an. Die Form der verwendeten Kalibrierungsspulen ist im Prinzip beliebig, solange das erzeugte Magnetfeld numerisch oder analytisch an den Orten der Gradiometerspulen berechnet werden kann.

Das gezeigte Prinzip läßt sich auf Gradiometer beliebiger hoher Ordnung erweitern. Für Gradiometer n-ter Ordnung muß lediglich dafür gesorgt werden, daß die von den Kalibrierungsspulen erzeugten Feldverteilungen derart gewählt werden, daß die Feldgradienten bis zur (n-1)-ten Ordnung zu Null werden. Die hierfür benötigte Feldverteilung kann direkt aus der Formel für den Feldgradienten, den das jeweilige Gradiometer mißt, abgelesen werden. Um diese Magnetfeldverteilung zu erzeugen, sind mindestens (n + 1) Kalibrierungsspulen erforderlich, wobei n die Ordnung des Gradiometers ist.

Der exakte Abstand der Kalibrierungsspulen zu den Gradiometerspulen und das Verhältnis der Windungszahlen zwischen den Kalibrierungsspulen, die benötigt werden, um eine bestimmte Feldverteilung zu erzeugen, läßt sich mit Hilfe einer Optimierungsrechnung ermitteln.

## Ansprüche

1. Verfahren zum Kalibrieren von Mehrkanal-Squid-Systemen mit Gradiometern beliebiger Ordnung mit Hilfe von definierten, an den Orten der Pickup-Spule und der oder den Kompensationsspule(n) auftretenden und numerisch berechenbaren Kalibrierungs-Magnetfeldern, **dadurch gekennzeichnet,** daß jede Gradiometerspule (Pickup-Spule, Kompensationsspule) von den gemeinsamen, entgegengesetzt gerichteten Magnetfeldern zweier Kalibrierungsspulen gleicher Amperewindungszahl durchdrungen wird, die axialsymmetrisch und in gleichen Abständen zu den Gradiometerspulen diesen zugeordnet sind, und das Feld, das die Kalibrierungsspulen an den Orten der Gradiometerspulen hervorrufen, numerisch berechnet und durch die gemessene Spannung am Ausgang der zugeordneten SQUID-Elektronik zur Bestimmung des Kalibrierungsfaktors dividiert wird.

2. Anordnung zur Durchführung des Verfahrens nach Anspruch 1, **dadurch gekennzeichnet,** daß bei einem Gradiometer ersten Grades die den beiden Gradiometerspulen (1, 2) zugeordneten Kalibrierungsspulen (4, 5) um gleiche axiale Abstände gegenüber den zugeordneten Gradiometerspulen (1, 2) nach außen versetzt angeordnet sind.

3. Anordnung zur Durchführung des Verfahrens nach Anspruch 1, **dadurch gekennzeichnet,** daß bei einem Gradiometer zweiten Grades die den beiden äußeren Gradiometerspulen (1, 2) zugeordneten Kalibrierungsspulen (5, 6) um gleiche axiale Abstände gegenüber den zugeordneten Gradiometerspulen nach außen versetzt angeordnet sind und die Spulenebenen der mittleren Gradiometerspule (3) und der dieser zugeordneten Kalibrierungsspule (6) zusammenfallen.

FIG 1

FIG 2

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | REVIEW OF SCENTIFIC INSTRUMENTS, Band 53, Nr. 12, Dezember 1982, Seiten 1815-1845, American Institute of Physics, New York, US; G.L. ROMANI et al.: "Biomagnetic instrumentation" * Seite 1829, Spalte 2, Zeile 23 – Seite 1830, Spalte 1, Zeile 18; Figur 15 * --- | | G 01 R 33/022 |
| D,A | IEEE TRANSACTIONS ON BIOMEDICAL ENGINEERING, Band 35, No. 7, Juli 1988, Seiten 351-560, IEEE, New York, US; P.C. RIBEIRO et al.: "Squid arrays for simultaneous magnetic meausrements: Calibration and source localization performance" --- | | |
| A | GB-A-2 115 552 (EMI LTD) --- | | |
| A | PATENT ABSTRACTS OF JAPAN, (P-384), 31. August 1985; & JP-A-60 073 474 (NIPPON HOSO KYOKAI) 30-09-1983 ----- | | |

| | RECHERCHIERTE SACHGEBIETE (Int. Cl.5) |
|---|---|
| | G 01 R 33 |

Der vorliegende Recherchenbericht wurde für alle Patentansprüche erstellt

| Recherchenort | Abschlußdatum der Recherche | Prüfer |
|---|---|---|
| DEN HAAG | 08-12-1989 | HAASBROEK J.N. |